Europäisches Patentamt

European Patent Office

Office européen des brevets

(19)

(11) Numéro de publication : **0 299 037 B1**

(12) **FASCICULE DE BREVET EUROPEEN**

(45) Date de publication du fascicule du brevet :
**01.04.92 Bulletin 92/14**

(51) Int. Cl.⁵ : **H01L 21/76, H01L 21/308,
H01L 21/00**

(21) Numéro de dépôt : **88901279.5**

(22) Date de dépôt : **26.01.88**

(86) Numéro de dépôt international :
**PCT/FR88/00041**

(87) Numéro de publication internationale :
**WO 88/05602 28.07.88 Gazette 88/17**

(54) **PROCEDE DE FABRICATION DE ZONES D'ISOLATION ELECTRIQUE DANS UN CIRCUIT INTEGRE CMOS.**

(30) Priorité : **26.01.87 FR 8700861**

(43) Date de publication de la demande :
**18.01.89 Bulletin 89/03**

(45) Mention de la délivrance du brevet :
**01.04.92 Bulletin 92/14**

(84) Etats contractants désignés :
**DE FR GB IT NL**

(56) Documents cités :
**EP-A- 0 036 111
EP-A- 0 098 775
EP-A- 0 111 086
EP-A- 0 164 737**

(56) Documents cités :
**PATENT ABSTRACTS OF JAPAN, vol. 10, No:
104 (E-397), 19 April 1986, page 2161 & JP, A,
60244043 (TOSHIBA K.K.) 3 December 1985,
see abstract
PATENT ABSTRACTS OF JAPAN, vol. 10, No:
104 (E-397), 19 April 1986, page 2161 & JP, A,
60244037 (TOSHIBA K.K.) 3 December 1985**

(73) Titulaire : **COMMISSARIAT A L'ENERGIE
ATOMIQUE Etablissement de Caractère
Scientifique Technique et Industriel
31/33, rue de la Fédération
F-75015 Paris (FR)**

(72) Inventeur : **JEUCH, Pierre
13, rue du Parc
F-38170 Seyssins (FR)**

(74) Mandataire : **Lhoste, Catherine et al
BREVATOME 25, rue de Ponthieu
F-75008 Paris (FR)**

**Description**

La présente invention a pour objet un procédé de fabrication de zones d'isolation électrique dans un circuit intégré CMOS.

Elle s'applique en particulier dans le domaine de la microélectronique chaque fois qu'il est nécessaire d'isoler électriquement les uns des autres les composants n et p d'un circuit (transistors, diodes, etc...) réalisé sur un substrat en silicium monocristallin. En particulier, l'invention peut être utilisée pour la réalisation de portes logiques, de bascules, de mémoires mortes ou vives, etc.

La recherche d'une forte densité d'intégration dans les circuits intégrés CMOS nécessite d'utiliser une technique d'isolement spéciale entre les différents composés de ces circuits et notamment entre leurs transistors à canal n et leurs transistors à canal p.

L'une des techniques récentes d'isolation utilisée dans ce but est basée sur la réalisation d'une tranchée d'isolement dans le substrat semi-conducteur, tranchée que l'on oxyde ensuite puis que l'on remplit par un matériau tel que du silicium polycristallin ou de l'oxyde de silicium. Ce remplissage se fait par le dépôt du matériau de remplissage, sur toute la surface du circuit intégré, suivi de l'enlèvement de l'excédent dudit matériau déposé hors des tranchées. On réalise ensuite au-dessus de la tranchée un oxyde de champ localisé (LOCOS).

Cette technique d'isolement par tranchée surmontée d'un oxyde de champ localisé a notamment été décrite dans un article IEDM de 1982, pages 237 à 240, intitulé "Deep Trench Isolated CMOS Devices".

Cette technique d'isolation permet d'atteindre de grandes profondeurs d'isolation (plusieurs micro-mètres) entre les différents composants du circuit intégré, tout en assurant une bonne isolation en surface et tout en évitant la mise en court-circuit des transistors à canal n et des transistors à canal p, phénomène connu sous le nom de "latch up".

Malheureusement, dans une telle technique d'isolation, se pose le problème d'une inversion de conductivité électrique sur les flancs des tranchées d'isolement et donc de la formation de canaux parasites lorsque l'extrémité des canaux des transistors touchent les tranchées, là où les grilles des transistors passent sur les tranchées. Ce problème de canaux parasites est en particulier décrit dans un article IEDM de 1983, pages 23 à 26 intitulé "Characterization and Modeling of the Trench Surface Inversion Problem for the Trench Isolated CMOS Technology" de Kit M. CHAM et al. ; il nécessite d'éloigner les transistors des tranchées d'isolement et plus spécialement les transistors à canal n de ces circuits, en réalisant une région d'oxyde de champ entre les tranchées et les transistors à l'endroit où la grille de ces transistors passe sur l'isolation latérale correspondante de ces transistors, limitant ainsi la densité d'intégration de ces circuits.

Par ailleurs, le positionnement des tranchées d'isolement entre les régions n et les régions p du substrat dans lesquelles seront réalisés respectivement les transistors à canal p et les transistors à canal n du circuit intégré nécessite l'utilisation de plusieurs masques de lithographie, un masque pour définir l'emplacement des régions n et un masque pour définir l'emplacement des régions p ;difficiles à positionner l'un par rapport à l'autre et limitant encore la densité d'intégration des circuits CMOS.

Des documents JP-A-60 244 043, JP-A-244 044 et JP-A-60 244 037 sont connus des procédés de fabrication de zones d'isolation électriques servant à isoler les regions n des regions p d'un circuit intégré CMOS. Une tranchée d'isolement est formée de telle manière qu'elle présente un flanc vertical avec la région de type n et un flanc incliné où présentant un échelon avec la région de type p, le fond, le flanc incliné, respectivement l'échelon sont surdopés afin d'éviter la formation de canaux parasites.

La présente invention a pour objet un procédé de fabrication de zones d'isolation électrique dans un circuit intégré CMOS permettant de remédier aux différents inconvénients donnés ci-dessus.

En particulier, le circuit intégré obtenu selon l'invention, utilisant la technique d'isolation par tranchées d'isolement, présente une densité d'intégration nettement plus élevée que celle des circuits CMOS de l'art antérieur. En outre, ce circuit ne présente pas d'inversion de conductivité électrique sur les flancs des tranchées, et, donc de canaux parasites.

De façon plus précise, l'invention a pour objet un procédé de fabrication de zones d'isolation électrique servant à isoler les régions n des régions p d'un circuit intégré CMOS formées dans un substrat en silicium, caractérisé en ce qu'il comprend les étapes suivantes :

(a) réalisation d'un premier masque à la surface du substrat, comportant des premiers motifs masquant au moins en partie les régions p,

(b) réalisation d'un second masque à la surface du substrat, comportant des seconds motifs masquant au moins en partie les régions n, le second masque pouvant être gravé sélectivement par rapport au premier masque, les premier et second motifs étant disjoints et définissant entre eux l'emplacement et la largeur des tranchées d'isolation électrique à réaliser entre les régions n et les régions p,

(c) première gravure anisotrope des régions du substrat non masquées pour former lesdites tranchées,

(d) gravure isotrope des motifs du premier masque et, simultanément seconde gravure anisotrope du substrat pour former, dans la partie supérieure des tranchées, des flancs inclinés au contact des régions p, la section des tranchées allant en s'élargissant vers ta surface supérieure du substrat,

(e) surdosage de type p des flancs inclinés des tranchées.

Par "substrat" il faut comprendre un substrat massif ou une couche épitaxiée sur un substrat massif.

L'utilisation d'une tranchée d'isolement comportant des flancs dissymétriques permet en particulier un surdopage des flancs des tranchées au contact des regions p permettant ainsi de placer les transistors à canal n du circuit au contact des tranchées et en particulier les zones actives n+ de ces transistors. Ceci permet de diminuer notablement la distance entre les régions n et p et donc d'augmenter la densité d'intégration du circuit.

En effet, ce surdopage permet d'éviter toute inversion de conductivité électrique sur les flancs des tranchées d'isolement et en particulier du côté des transistors à canal n.

Selon un mode préféré de mise en oeuvre de l'invention, le procédé de fabrication comprend les étapes suivantes :

a') réalisation d'un masque sur la surface supérieure du substrat comportant des motifs masquant les régions n ou p,

b') dépôt sur le substrat et le masque d'une couche d'un premier matériau qui peut être gravé sélectivement par rapport à un second matériau et au masque, cette couche présentant des parties en surplomb sur les motifs dudit masque,

c') dépôt d'une couche de second matériau audessus de la couche de premier matériau,

d') gravure anisotrope de la couche de second matériau jusqu'à mise à nu des parties en surplomb de la couche de premier matériau,

e') élimination des régions de la couche de premier matériau mises à nu tors de l'étape d',

(f') première gravure anisotrope des régions du substrat mises à nu lors de l'étape précédente afin de former des tranchées,

g') gravure isotope du matériau situé au-dessus des régions p et seconde gravure anisotrope du substrat pour former dans la partie supérieure des tranchées des flancs inclinés situés au contact des régions p, ta section des tranchées allant en s'élargissant vers la surface supérieure du substrat,

(h') surdopage de type p des flancs inclinés des tranchées,

(i') remplissage des tranchées par un matériau de remplissage.

Ce mode de mise en oeuvre permet un autopositionnement des masques lithographiques conduisant à une simplification du procédé ainsi qu'à un accroissement supplémentaire de la densité d'intégration du circuit.

De préférence, le second matériau est de la résine et les motifs du masque masquent les régions p du circuit intégré.

Le procédé selon l'invention s'applique aussi bien pour une technologie utilisant des caissons de type p, des caissons de type n ou des doubles caissons n et p.

Lors de l'utilisation de caissons n, en particulier dans un substrat de type p, on effectue une implantation d'ions de type n entre les étapes a' et b' pour former les régions n, en utilisant le masque réalisé lors de l'étape a',

Lors de l'utilisation de caissons p, en particulier dans un substrat de type n, on effectue, entre les étapes g' et h' une implantation d'ions de type p, en utilisant la première couche de matériau gravée au cours de l'étape e' du procédé comme masque.

Dans le cas d'une technologie à doubles caissons, les deux implantations ci-dessus doivent bien entendu être réalisées.

Pour améliorer la planéité de la surface supérieure de la seconde couche de résine, notamment dans le cas de caissons de grandes dimensions, il est avantageux de réaliser un second masque de lithographie complémentaire ou précédent, définissant les dimensions et emplacements des régions p.

Toutefois, ce second masque, formé juste avant de déposer la seconde couche de résine et gravé simultanément à cette couche de résine lors de l'étape d, n'a pas besoin d'un positionnement précis à l'inverse des procédés de l'art antérieur. En effet, le masque d'implantation des régions p est constitué par ce qui reste de résine (second masque + couche de résine) après l'étape d. Ceci permet un autopositionnement des tranchées d'isolement par rapport aux régions p du circuit intégré, autopositionnement qui n'est pas possible avec les procédés de l'art antérieur.

Afin de faire diffuser les ions de type n et/ou de type p implantés dans le substrat, on effectue au moins un recuit thermique de la structure.

La gravure simultanée du masque des régions p et du substrat pour former les flancs inclinés est notamment décrite dans un article paru dans le Journal of Electrochemical Society d'août 1986, intitulé "Tapered $SiO_2$ Etch in Diode-Type Reactive Ion Etching" pp 1666-1670.

De façon avantageuse, on effectue avant l'étape a le dépôt sur le substrat d'au moins une couche protectrice puis l'élimination des régions de cette couche protectrice mises à nu lors de l'étape e', entre les étapes e' et f'. Cette couche protectrice gravée peut être utilisée en particulier comme masque pour réaliser un oxyde de champ localisé, auto-positionné par rapport aux tranchées d'isolement au-dessus desquelles il est réalisé.

D'autres caractéristiques et avantages de l'invention ressortiront mieux de la description qui va suivre, donnée à titre illustratif et non limitatif, en référence aux figures 1 à 8 annexées représentant schématiquement, en coupe longitudinale, les différentes étapes du procédé de fabrication d'un circuit intégré CMOS conforme à l'invention et aux figures 9 et 10 illustrant une variante de ce procédé.

La description qui va suivre est relative à la fabrication de zones d'isolation électrique d'un circuit CMOS à double caisson n et p, réalisé sur un substrat semiconducteur de type p.

Bien entendu le procédé de l'invention est d'application beaucoup plus générale, comme on l'a vu précédemment.

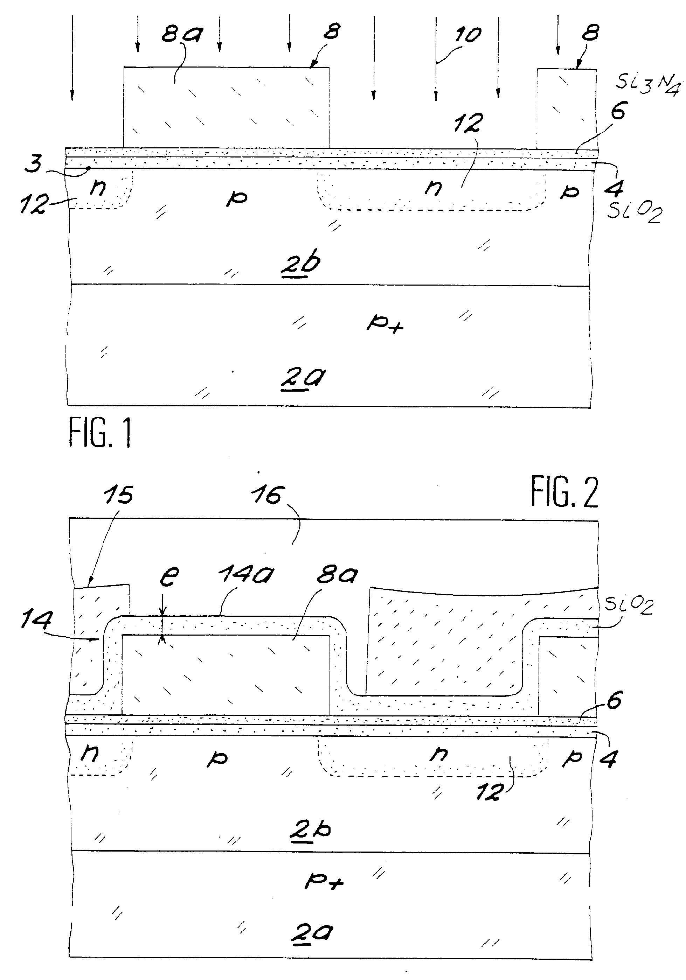

Comme représenté sur les figures 1 à 8, le substrat en silicium monocristallin sur lequel va être réalisé le circuit intégré et ses zones d'isolation, comprend une zone 2a de type p+ comportant au moins $10^{16}$ atomes par $cm^3$ d'ions de bore à partir de laquelle, une couche 2b de type p a été épitaxiée. Dans cette couche 2b seront réalisés ultérieurement les transistors à canal n et à canal p du circuit.

La concentration d'impuretés de type p dans le substrat, plus élevée en profondeur (zone 2a) qu'en surface (zone 2b) permet d'éviter selon un procédé bien connu le verrouillage (latch up) de la structure n+pnp+ réalisée par les sources n+ et p+ des transistors à canal n et à canal p, la couche p et le caisson n.

Sur la surface 3 de la couche 2b on forme éventuellement une couche isolante 4 de préférence en oxyde de silicium ($SiO_2$). Cette couche 4 peut être formée par oxydation thermique de la couche 2b en silicium à une température de l'ordre de 900°C. Cette couche 4 présente une épaisseur de 20 nm environ.

Sur cette couche d'oxyde 4, on dépose ensuite une autre couche d'isolant 6 de préférence en nitrure de silicium ($Si_3N_4$) qui sert de couche de protection des caissons n et p ainsi que pour la localisation de l'oxyde de champ réalisé ultérieurement. Cette couche 6 présente une épaisseur d'environ 80 nm et peut être obtenue par un dépôt chimique en phase vapeur (CVD ou LPCVD).

La couche d'oxyde de silicium 4 sert de couche de soutien à cette couche de nitrure de silicium 6.

L'étape suivante du procédé consiste à réaliser un premier masque de lithographie 8 définissant les dimensions et l'emplacement des régions ou caissons n dans lesquelles seront réalisés ultérieurement les transistors à canal p du circuit CMOS ; ce masque 8 représentant l'image des régions n comporte des motifs 8a qui permettent de ne masquer que les régions du substrat dans lesquelles seront réalisées les régions p.

Ce masque de lithographie 8 peut être un masque tricouche constitué d'une première couche de résine de 4000 nm, recouverte d'une couche de $SiO_2$ de 150 nm, déposée par dépôt chimique en phase vapeur assisté plasma (PECVD), elle même surmontée d'une seconde couche de résine novolaque de 1200 nm.

La première couche de résine est réalisée en une résine telle que celles généralement utilisées en photolithographie ; son dépôt est suivi d'une cuisson à 250°C pendant 15 minutes afin d'obtenir un bon étalement de cette couche de résine.

Les motifs du masque tricouche 8 sont réalisés de façon connue en réalisant dans la seconde couche de résine un masque formé par photolithographie, puis en soumettant l'empilement des couches sous-jacentes de $SiO_2$ et de résine à une gravure anisotrope du type ionique réactive, utilisant comme agent d'attaque du $CHF_3$ puis de l'oxygène pour graver successivement la couche de $SiO_2$ et la première couche de résine.

A l'aide de ce masque 8, on effectue ensuite une implantation 10 d'ions de type n en vue de former des régions 12 ou caissons n dans lesquels seront réalisés ultérieurement les transistors à canal p. Cette implantation ionique peut être réalisée avec des ions de phosphore à une dose de $1.10^{13}$ atomes/$cm^2$, avec une énergie de 200 keV.

L'étape suivante du procédé, comme représenté sur la figure 2, consiste à déposer une couche 14 en un matériau qui peut être gravé sélectivement par rapport au masque 8 et par rapport aux résines généralement utilisées en photolithographie.

En particulier, cette couche 14 est réalisée en oxyde de silicium ($SiO_2$) et est déposée par une technique de dépôt , isotrope tel qu'un dépôt chimique en phase vapeur assisté plasma, à une température de l'ordre de 200°C. Cette couche d'oxyde 14 présente une épaisseur de 500 nm environ. En outre, compte tenu de la présence du masque tricouche 8, cette couche 14 comporte des parties en surplomb 14a en regard des caissons p.

Cette couche d'oxyde 14, après gravure, servira de masque pour graver les tranchées d'isolement dans le substrat.

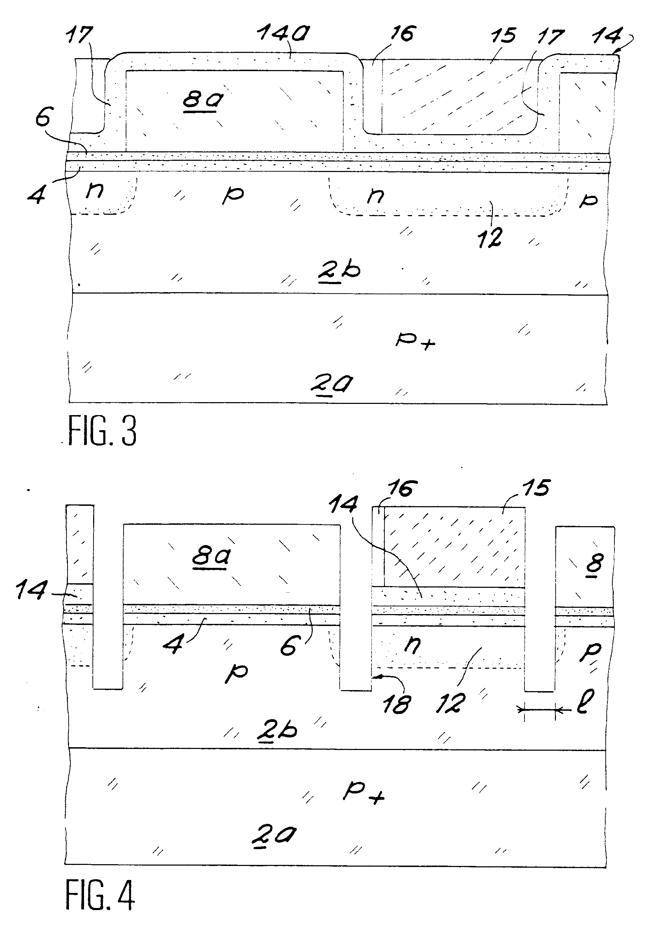

L'étape suivante du procédé consiste à former un second masque 15 en résine définissant les dimensions et le positionnement des régions ou caisson p à réaliser. Ce second masque 15 qui peut être décalé par rapport au premier masque 8 (voir figure 2) sert essentiellement à combler les parties en creux telles que les parties en creux 14b de la structure afin d'obtenir ultérieurement, juste avant l'étape de gravure de la couche 14 de $SiO_2$ (figure 3), une structure parfaitement plane.

Cet apport de résine dans les parties 14b se justifie compte tenu de la largeur éventuellement élevée (de l'ordre de 300 micromètres) des caissons n.

Sur la structure obtenue, on dépose ensuite une couche de résine 16 telle que celle utilisée classiquement en photolithographie, présentant une épaisseur de 4000 nm. Après dépôt de cette couche 16 on effectue une cuisson à 250°C pendant un quart d'heure environ afin à obtenir un bon étalement de cette couche de résine.

On effectue ensuite une gravure de la couche de résine 16 et du masque 15 jusqu'à élimination totale de la résine située au-dessus de la région en surplomb 14a de la couche d'oxyde. Cette gravure est réalisée en utilisant un plasma d'oxygène. La structure obtenue est celle représentée sur la figure 3.

La couche de résine 16 et le masque en résine 15 ainsi gravé constitueront ultérieurement le masque d'implantation des ions de type p pour former les caissons du circuit intégré.

L'étape suivante du procédé consiste à graver la couche d'oxyde de silicium 14 afin d'éliminer les régions de cette couche non masquées par le restant de la couche de résine 16 et le restant du masque 15, et en particulier les régions en surplomb 14a et les flancs isolants 17 du masque 8. Cette gravure est une gravure pleine plaque du type ionique réactive utilisant du $CHF_3$ comme agent d'attaque. La structure obtenue est celle représentée sur la figure 4.

On effectue ensuite une gravure de la couche de nitrure de silicium 6 puis de la couche d'oxyde de silicium 4 en vue d'éliminer les régions de ces couches mises à nu lors de l'étape précédente, non recouvertes de la résine 16 et du masque 15 gravés ainsi que du masque 8. Les gravures utilisées sont des gravures ioniques réactives utilisant comme agent d'attaque du $CHF_3$.

On effectue ensuite, comme représenté sur la figure 4, une gravure des régions du substrat mises à nu lors de l'étape précédente afin de former les tranchées d'isolement 18. La gravure du substrat est réalisée sur une profondeur de l'ordre de 5000 nm par un procédé de gravure ionique réactive sélectif par rapport à la résine de la couche 16 et du masque 15 ainsi que par rapport au masque 8. A cet effet, on utilise comme agent d'attaque de l'hexafluorure de soufre ($SF_6$).

Conformément à un mode préféré de l'invention, la largeur minimale $\underline{l}$ des tranchées 18 est égale à l'épaisseur $\underline{e}$ de la couche d'oxyde de silicium 14, (figure 2), déposée de façon isotrope et donc voisine de 500 nm.

Le procédé selon l'invention permet donc la réalisation de tranchées d'isolement 18 submicroniques contrairement au procédé actuellement connu d'isolation par tranchées. L'obtention de tranchées submicroniques permet d'augmenter de façon considérable la densité d'intégration du circuit intégré.

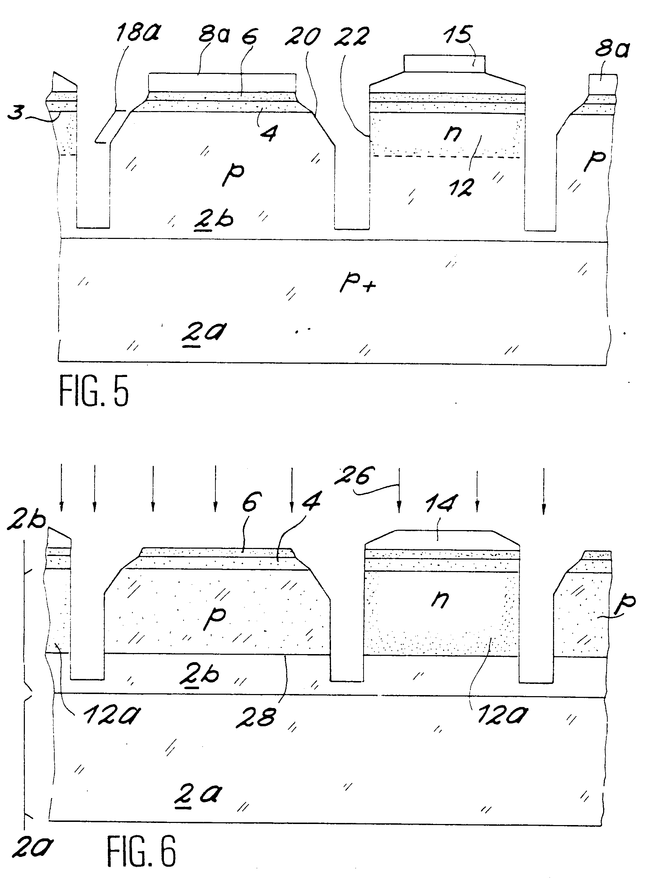

L'étape suivante du procédé consiste à former comme représenté sur la figure 5, dans la partie supérieure 18a des tranchées 18 des flancs dissymétriques ; les flancs 20 au contact des régions p sont inclinés par rapport à la surface 3 de la couche en silicium 2b, alors que les flancs 22 au contact des régions n sont perpendiculaires à la surface 3 de la couche 2b. Les flancs 20 sont inclinés de façon que la section des tranchées est maximum au niveau de la surface 3 du substrat.

Pour former ces flancs inclinés 20, on effectue une gravure anisotrope des couches 4, 6 et de la partie supérieure 18a du substrat en consommant la résine 16 et 15 ainsi que le masque 8 de façon isotrope. Cette gravure est par exemple une gravure ionique réactive utilisant comme décrit dans le document Electrochemical cité ci-dessus.

Ensuite, on élimine le restant de la couche de résine 15 et le restant du masque 8 non consommés lors de l'attaque précédente par dissolution dans de l'acide nitrique. La structure obtenue est alors celle représentée sur la figure 6.

On effectue ensuite une implantation d'ions 26 de type p afin de former les caissons p portant la référence 28 dans lesquels seront réalsiés ultérieurement les transistors à canal n. Cette implantation 26 peut être réalisée avec des ions de bore à une dose de $2,5.10^{12}$ atomes/$cm^2$ et une énergie de 60 keV. On effectue alors un recuit de la structure à 1175°C pendant 5 heures environ afin de faire diffuser dans le substrat, et plus précisément dans la couche 2b, les ions de bore implantés ainsi que les ions de phosphore implantés auparavant. Les caissons n ainsi diffusés portent la référence 12a.

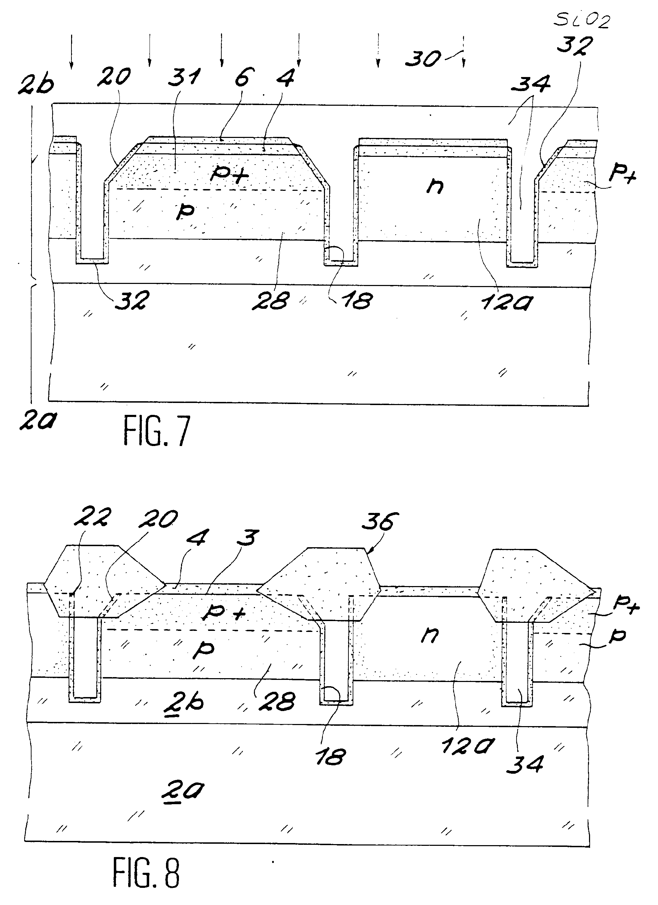

L'étape suivante du procédé consiste à effectuer un surdopage des flancs inclinés 20 adjacents aux caissons p 28 en vue d'éviter l'inversion de conductivité électrique sur les flancs des tranchées d'isolement 18 et donc la formation de canaux parasites. Ce surdopage peut être réalisé par une implantation 30 de $BF_2$ à une dose de $5.10^{13}$ atomes/$cm^2$ et une énergie de 40 keV ; il porte la référence sur la figure 7.

On élimine ensuite le restant de la couche d'oxyde de silicium 14 par une gravure chimique humide en utilisant un mélange d'acide fluorhydrique et de fluorure d'ammonium,

On effectue alors une oxydation thermique de la structure, en atmosphère d'oxygène à une température de l'ordre de 900°C. Cette oxydation permet d'obtenir un film d'oxyde 32 d'environ 100 nm recouvrant en particulier les flancs et le fond de la tranchée 18 et accessoirement la couche de nitrure de silicium 6. Cette oxydation thermique permet d'améliorer l'isolation électrique par tranchée d'isolation,

On effectue alors le remplissage de la tranchée par un matériau 34 constitué par du silicium polycristallin ou un siliciure ($WSi_2$ par exemple). Ce remplissage est réalisé par un depôt isotrope et notamment par la technique de dépôt chimique en phase vapeur (CVD ou LPCVD) de manière à remplir complétement les tranchées 18.

Après ce remplissage des tranchées 18, on élimine l'excédent de matériau de remplisage 34 se trouvant hors des tranchées 18 de façon à ne laisser du matériau 34 qu'à l'intérieur des tranchées 18, comme représenté sur la figure 8. Cette élimination est réalisée par une gravure sèche pleine plaque du type ionique réactive avec du $CCl_4$, attaque sélective par rapport à la couche de nitrure de silicium 6.

On réalise ensuite l'oxyde de champ localisé 36, de façon classique, en protégeant les régions actives (transistors) du circuit à réaliser, en éliminant les zones de la couche de nitrure 6 non masquées, en oxydant thermiquement à 900°C le matériau de remplissage 34 des tranchées ainsi que te substrat 2b en silicium dans les régions qui ne sont plus recouvertes de nitrure de silicium, la couche de nitrure de silicium 6 gravée servant à la localisation de cet oxyde de champ 36. L'épaisseur de cet oxyde est voisine de 600 nm.

Enfin, on élimine la couche de nitrure de silicium 6, par exemple par une gravure chimique à l'aide de l'acide orthophosphorique. La structure finale du circuit CMOS est celle représentée sur la figure 8.

Grâce au procédé de l'invention, l'oxyde de champ localisé 36 est autopositionné par rapport aux tranchées d'isolement 18. Ceci contribue à augmenter de façon notable la densité d'intégration des circuits intégrés CMOS.

Les transistors à canal n et les transistors à canal p du circuit CMOS peuvent alors être réalisés de façon classique respectivement dans les caissons p 28 et n 12a.

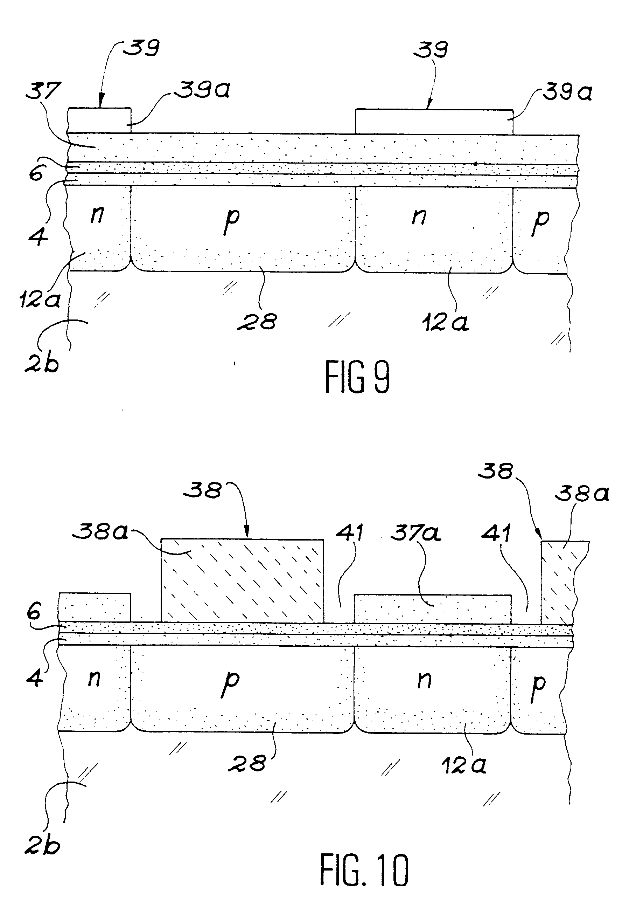

La description ci-dessus concernait une mise en oeuvre de l'invention dans laquelle les masques 8 et 15 sont complémentaires et auto-positionnés, la position des motifs 8a du masque 8 fixant celle des motifs du masque 15. Il est toutefois possible d'utiliser des masques non auto-positionnés pour la mise en oeuvre du procédé de l'invention ; ceci est schématisé sur les figures 9 et 10.

Après réalisation de façon connue des caissons n 12a et p 28 par implantation d'ions respectivement de phosphore et de bore dans le substrat 2b en silicium puis recuit d'implantation, on dépose successivement la couche 4 d'oxyde de silicium et la couche 6 de nitrure de silicium.

On dépose alors une couche 37 de 0,8 micromètre d'épaisseur sur la couche 6 en un matériau résistant à une gravure de silicium et de résine et en particulier en siliciure tel que PtSi, $CoSi_2$ ou en $SiO_2$. Pour une couche 37 en $SiO_2$ le dépôt est effectué par LPCVD (dépôt chimique en phase vapeur à basse pression).

On forme alors par les procédés classiques de photolithographie un masque 39, dont les motifs 39a masquent les caissons ou régions n 12a, puis on élimine les régions non masquées de la couche 37, comme schématisé sur la figure 9. Pour une couche 37 en $SiO_2$ la gravure est une gravure ionique réactive utilisant du $CHF_3$ comme agent d'attaque. On obtient ainsi des motifs 37a masquant les régions 12a.

Après élimination du masque de résine 39 avec un plasma d'$O_2$, on réalise un second masque de lithographie 38 dont les motifs 38a masquent en partie les régions 28 de type p. Ce masque 38 est de même nature que le masque 8 utilisé précédemment (figures 1-5) ; il joue le même rôle que ce dernier et est réalisé de la même façon, les motifs 37a du premier masque et ceux 38a du second masque sont alternés et les espaces 41 situés entre deux motifs 37a et 38a définissent l'emplacement et la largeur des tranchées d'isolement à réaliser.

On effectue ensuite une gravure des régions du substrat non recouvertes des motifs 37a et 38a afin de former les tranchées d'isolement, comme indiqué précédemment (figure 4). La suite du procédé est identique à celle décrite ci-dessus en référence aux figures 5 à 8.

## Revendications

1. Procédé de fabrication de zones d'isolation électrique (18, 34, 36) servant à isoler les régions n (12a) des régions p (28) d'un circuit intégré CMOS formées dans un substrat en silicium (2b), comprenant les étapes suivantes :

    (a) réalisation d'un premier masque (8, 38) à la surface (3) du substrat (2b), comportant des premiers motifs (8a, 38a) masquant au moins en partie les régions p (28),

    (b) réalisation d'un second masque à la surface (3) du substrat, comportant des seconds motifs (15, 16, 37a) masquant au moins en partie les régions n (12a), le second masque pouvant être gravé sélectivement par rapport au premier masque, les premier et second motifs étant disjoints et définissant entre eux l'emplacement et la largeur (l) des tranchées d'isolement électrique (18) à réaliser entre les régions n (12a) et les régions p (28),

    (c) première gravure anisotrope des régions du substrat (2b) non masquées pour former lesdites tranchées (18),

    (d) gravure isotrope des motifs du premier masque (8, 38) et, simultanément, seconde gravure anisotrope du substrat (2b) pour former, dans la partie supérieure (18a) des tranchées (18), des flancs inclinés (20) au contact des régions p (38), la section des tranchées (18) allant en s'élargissant vers la surface supérieure (3) du substrat,

    (e) surdopage (31) de type p des flancs inclinés (20) des tranchées.

2. Procédé de fabrication selon la revendication 1, caractérisé en ce que l'on remplit les tranchées (18) par un matériau de remplissage (32, 34).

3. Procédé de fabrication de zones d'isolation électrique (18, 34, 36) servant à isoler les régions n (12a) des régions p (28) d'un circuit intégré CMOS formées dans un substrat en silicium (2b), comprenant les étapes successives suivantes :

    a') réalisation d'un masque sur la surface supérieure du substrat (2b) comportant des motifs (8a, 38a, 37a) masquant les régions n (12a) ou p (28),

b') dépôt sur le substrat (2b) et le masque (8) d'une couche (14) d'un premier matériau qui peut être gravé sélectivement par rapport à un second matériau (16) et au masque (8), cette couche (14) présentant des parties en surplomb (14a) sur les motifs dudit masque (8),

c') dépôt d'une couche de second matériau (16) au-dessus de la couche de premier matériau (14),

d') gravure arisotrope de la couche te second matériau (16) jusqu'à mise à nu des parties en surplomb (14a) de la couche te premier matériau (14),

e') élimination des régions (14a, 17) de la couche (14) te premier matériau mises à nu lors de l'étape d',

f') première gravure anisotrope des régions du substrat mises à nu lors de l'étape précédente afin de former des tranchées (18).

g') gravure isotrope du matériau (8, 38) situé au-dessus des régions p et simultanément seconde gravure anisotrope du substrat (2b) pour former dans la partie supérieure (18a) des tranchées (18) des flancs inclinés (20) situés au contact des régions p (38), la section des tranchées (18) allant en s'élargissant vers la surface supérieure (3) du substrat,

h') surdopage (31) de type p des flancs inclinés (20) des tranchées,

i') remplissage des tranchées (18) par un matériau de remplissage (32, 34).

4. Procédé de fabrication selon la revendication 3, caractérisé en ce que les motifs (8a, 38a) masquent les régions p (28).

5. Procédé de fabrication selon la revendication 4, caractérisé en ce que le second matériau (16) est de la résine.

6. Procédé de fabrication selon l'une quelconque des revendications 3 à 5, caractérisé en ce que l'on effectue une implantation (10) d'ions de type n entre les étapes a' et b' pour former les régions n (12a).

7. Procédé de fabrication selon l'une quelconque des revendications 3 à 6, caractérisé en ce que l'on effectue une implantation (26) d'ions de type p entre les étapes g' et h' pour former les régions p (28).

8. Procédé de fabrication selon la revendication 6 ou 7, caractérisé en ce que l'on effectue entre les étapes o' et i' un recuit pour faire diffuser les ions implantés dans le substrat (2b).

9. Procédé de fabrication selon l'une quelconque des revendications 3 à 8, caractérisé en ce que l'on comble de résine (15) les régions de la structure situées entre les parties en surplomb (14a), avant de déposer la couche de second matériau (16), et en ce que l'on grave simultanément cette résine (15) et la couche (16) de second matériau au cours de l'étape d'.

10. Procédé de fabrication selon l'une quelconque des revendications 3 à 9, caractérisé en ce que l'on dépose sur le substrat au moins une couche protectrice (4, 6) avant l'étape a' et en ce que l'on élimine les régions de cette couche protectrice mises à nu lors de l'étape e' entre les étapes e' et f'.

11. Procédé de fabrication selon l'une quelconque des revendications 3 à 10, caractérisé en ce que l'on effectue entre les étapes h' et i' une oxydation thermique du substrat entraînant la formation d'un film d'oxyde (32) sur les flancs (20, 22) et le fond des tranchées (18).

12. Procédé de fabrication selon l'une quelconque des revendications 3 à 11, caractérisé en ce que l'on réalise après l'étape i' un oxyde de champ localisé (36) au-dessus de chaque tranchée (18).

13. Procédé de fabrication selon l'une quelconque des revendications 3 à 12, caractérisé en ce que l'on élimine le restant du masque (8) et le restant de la couche de second matériau (16) par gravure entre les étapes g' et h'.

14. Procédé de fabrication selon l'une quelconque des revendications 3 à 13, caractérisé en ce que l'on élimine le restant de la couche de premier matériau (14) entre les étapes h' et i'.

15. Procédé de fabrication selon l'une quelconque des revendications 2 à 14, caractérisé en ce que le matériau de remplissage est en silicium ou en siliciure.

**Patentansprüche**

1. Verfahren zum Herstellen elektrischer Isolationszonen (18, 34, 36), die der Isolierung der n-Bereiche (12a) von den p-Bereichen (28) einer integrierten CMOS-Schaltung dienen, die in einem Siliziumsubstrat (2b) ausgebildet sind, umfassend die folgenden Schritte:

(a) Herstellen einer ersten Maske (8, 38) auf der Oberfläche (3) des Subtrats (2b), die erste Muster (8a, 38a) aufweist, die wenigstens teilweise die p-Bereiche (28) maskieren,

(b) Herstellen einer zweiten Maske auf der Oberfläche (3) des Subtrats, die zweite Muster (15, 16, 37a) aufweist, die wenigstens teilweise die n-Bereiche (12a) maskieren, wobei die zweite Maske selektiv gegenüber der ersten Maske geätzt sein kann, die ersten und zweiten Muster voneinander getrennt sind und zwischen sich den Ort und die Größe (1) der elektrischen Isolationsgräben definieren, die zwischen den n-Bereichen (12a) und den p-Bereichen (28) herzustellen sind,

(c) eine erste anisotrope Ätzung der nicht maskierten Bereiche des Substrats (2b), um die genannten Gräben (18) auszubilden,

(d) isotrope Ätzung der Muster der ersten Maske (8, 38) und gleichzeitig anisotrope zweite Ätzung des Substrats (2b), um in dem oberen Bereich (18a) der Gräben (18) geneigte Flanken (20) in Berührung mit den p-Bereichen (38) auszubilden, wobei der Schnitt der Gräben (18) sich gegen die obere Oberfläche (3) des Substrats erweitert,

(e) Aufdotierung (31) vom p-Typ der geneigten Flanken (20) der Gräben.

2. Herstellungsverfahren nach Anspruch 1, **dadurch gekennzeichnt,** daß man die Gräben (18) mit einem Füllmaterial (32, 34) füllt.

3. Herstellungsverfahren für elektrische Isolationszonen (18, 34, 36), die dazu dienen, die n-Bereiche (12a) von den p-Bereichen (28) einer integrierten CMOS-Schaltung zu isolieren, die in einem Siliziumsubstrat (2b) ausgebildet sind, umfassend die folgenden, aufeinanderfolgenden Schritte:

(a′) Herstellung einer Maske auf der oberen Oberfläche des Substrats (2b), die Muster (8a, 38a, 37a) aufweisen, die n-Bereiche (12a) oder p-Bereiche (28) maskieren,

(b′) Abscheiden einer Schicht (14) aus einem ersten Material, das selektiv gegenüber einem zweiten Material (16) und der Maske (8) geätzt werden kann, auf dem Substrat (2b) und der Maske (8), wobei diese Schicht (14) Abschnitte (14a) aufweist, die über den Mustern der genannten Maske (8) liegen,

(c′) Abscheiden einer Schicht aus einem zweiten Material (16) über der Schicht (14) aus dem ersten Material,

(d′) anisotrope Ätzung der Schicht (16) aus dem zweiten Material bis zum Freilegen der Abschnitte (14a) der Schicht (14) aus dem ersten Material,

(e′) Entfernen der Bereiche (14a, 17) der Schicht (14) aus dem Ersten Material, die beim Schritt (d′) freigelegt worden sind,

(f′) erste anisotrope Ätzung der Bereiche des Substrats, die im vorangehenden Schritt freigelegt worden sind, um Gräben (18) auszubilden,

(g′) isotrope Ätzung des Materials (8, 38), das über den p-Bereichen liegt und gleichzeitig zweite anisotrope Ätzung des Substrats (2b), um in dem oberen Bereich (18a) der Gräben (18) geneigte Flanken (20) auszubilden, die in Berührung mit den p-Bereichen (38) sind, wobei der Querschnitt der Gräben (18) sich gegen die obere Oberfläche (3) des Substrats erweitert,

(h′) Aufdotierung (31) vom p-Typ der geneigten Flanken (20) der Gräben,

(i′) Füllen der Gräben (18) mit einem Füllmaterial (32, 34).

4. Herstellungsverfahren nach Anspruch 3, **dadurch gekennzeichnet,** daß die Muster (8a, 38a) die p-Bereiche (28) maskieren.

5. Herstellungsverfahren nach Anspruch 4, **dadurch gekennzeichnet,** daß das zweite Material (16) ein Harz ist.

6. Herstellungsverfahren nach einem der Ansprüche 3 bis 5, **dadurch gekennzeichnet,** daß man eine Ionenimplantation (10) vom n-Typ zwischen den Schritten (a′) und (b′) ausführt, um die n-Bereiche (12a) auszubilden.

7. Herstellungsverfahren nach einem der Ansprüche 3 bis 6, **dadurch gekennzeichnet,** daß man eine Ionenimplantation (26) vom p-Typ zwischen den Schritten (g′) und (h′) ausführt, um die p-Bereiche (28) auszubilden.

8. Herstellungsverfahren nach Anspruch 6 oder 7, **dadurch gekennzeichnet,** daß man zwischen den Schritten (g′) und (i′) eine Temperung durchführt, um die implantierten Ionen in das Substrat (2b) diffundieren zu lassen.

9. Herstellungsverfahren nach einem der Ansprüche 3 bis 8, **dadurch gekennzeichnet,** daß man Harz (15) auf die Bereiche der Struktur aufbringt, die zwischen den abgedeckten Bereichen (14a) liegen, bevor die Schicht (16) aus dem zweiten Material aufgebracht wird, und daß man gleichzeitig dieses Harz (15) und die Schicht (16) aus dem zweiten Material im Verlauf des Schrittes (g′) ätzt.

10. Herstellungsverfahren nach einem der Ansprüche 3 bis 9, **dadurch gekennzeichnet,** daß man auf das Substrat wenigstens eine Schutzchicht (4, 6) vor dem Schritt (a′) aufbringt, und daß man die Bereiche dieser Schutzschicht, die beim Schritt (e′) freigelegt worden sind, zwischen den Schritten (e′) und (f′) beseitigt.

11. Herstellungsverfahren nach einem der Ansprüche 3 bis 10, **dadurch gekennzeichnet,** daß man zwischen den Schritten (h′) und (i′) eine thermische Oxidation des Substrats ausführt, die die Ausbildung eines Oxidfilms (32) auf den Flanken (20, 22) und dem Boden der Gräben (18) hervorruft.

12. Herstellungsverfahren nach einem der Ansprüche 3 bis 11, **dadurch gekennzeichnet,** daß man nach dem Schritt (i′) eine örtliche Feldoxidation (36) über jedem Graben (18) ausführt.

13. Herstellungsverfahren nach einem der Ansprüche 3 bis 12, **dadurch gekennzeichnet,** daß man den Rest der Maske (8) und den Rest der zweiten Materialschicht (16) durch Ätzung zwischen den Schritten (g′) und (h′) entfernt.

14. Herstellungsverfahren nach einem der Ansprüche 3 bis 13, **dadurch gekennzeichnet,** daß man den Rest der ersten Materialschicht (14) zwischen den Schritten (h′) und (i′) entfernt.

15. Herstellungsverfahren nach einem der Ansprüche 2 bis 14, **dadurch gekennzeichnet,** daß das Füllmaterial aus Silizium oder einer Siliziumverbindung besteht.

**Claims**

1. Process for the production of electrical isolation zones (18, 34, 36) for isolating the n regions (12a) from the p regions (28) of a CMOS integrated circuit formed in a silicon substrate (2b), comprising the following stages:

(a) producing a first mask (8, 38) on the surface (3) of the substrate (2b), having first patterns (8a, 38a) masking at least partly the p regions (28),

(b) producing a second mask on the surface (3) of the substrate, having second patterns (15, 16, 37a) masking at least partly the n regions (12a), whereby the second mask can be selectively etched with respect to the first mask, the first and second patterns being separate and defining between them the location and the width (1) of the electrical isolation trenches (18) to be produced between the n regions (12a) and the p regions (28).

(c) first anisotropic etching the unmasked regions of the substrate (2b) for forming said trenches (18),

(d) isotropic etching of the patterns of the first mask (8, 38) and simultaneously second anistropic etching of the substrate (2b) for forming, in the upper part (18a) of the trenches (18), inclined sides (20) in contact with the p regions (38), the section of the trenches (18) widening toward the upper surface of the substrate (3),

(e) p type overdoping (31) of the inclined sides (20) of the trenches.

2. Production process according to claim 1, characterized in that the trenches (18) are filled a filling material (32, 34).

3. Process for the production of electrical isolation zones (18, 34, 36) for isolating the n regions (12a) from the p regions (28) of a CMOS integrated circuit formed in a silicon substrate (2b), comprising the following stages:

a') producing a mask on the upper surface of the substrate (2b) having patterns (8a, 38a, 37a) masking the n (12a) or p regions (28).

b') deposition on the substrate (2b) and the mask (8) of a layer (14) of a first material, which can be selectively etched with respect to a second material (16) and the mask (8), said layer (14) having parts (14a) overhanging the patterns of said mask (8).

c') deposition of a second material layer (16) above the first material layer (14),

d') anisotropic etching of the second material layer (16) until the overhanging parts (14a) of the first material layer (14) are exposed,

e') elimination of the regions (14a, 17) of the first material layer (14) exposed during stage d',

f') first anisotropic etching the regions of the substrate exposed during the preceding stage in order to form trenches (18),

g') isotropic etching of the material (8, 38) above the p regions and simultaneously second anisotropic etching of the substrate (2b) to form in the upper part (18a) of the trenches (18) inclined sides (20) located in contact with the p regions (38), the section of the trenches (18) widening towards the upper surface of the substrate (3),

h') p type overdoping (31) of the inclined sides (20) of the trenches,

i') filling the trenches (18) with a filling material (32, 34).

4. Production process according to claim 3, characterized in that the patterns (8a, 38a) mask the p regions (28).

5. Production process according to claim 4, characterized in that the second material (16) is resin.

6. Production process according to any one of the claims 3 to 5, characterized in that a n type ion implantation (10) takes place between stages a' and b' for forming n regions (12a).

7. Production process according to any one of the claims 3 to 6, characterized in that a p type ion implantation (26) takes place between stages g' and h' for forming p regions (28).

8. Production process according to claims 6 or 7, characterized in that between stages g' and i' an annealing is carried out in order to diffuse the implanted ions into substrate (2b).

9. Production process according to any one of the claims 3 to 8, characterized in that the regions of the structure located between the overhanging parts (14a) are filled with resin (15) prior to the deposition of the second material layer (16) and in that simultaneously said resin (15) and the second material layer (16) is etched during stage d'.

10. Production process according to any one of the claims 3 to 9, characterized in that on the substrate is deposited at least one protective layer (4, 6) prior to stage a' and in that the regions of said protective layer exposed during stage e' is eliminated between stages e' and f'.

11. Production process according to any one of the claims 3 to 10, characterized in that between stages h' and i' there is a thermal oxidation of the substrate leading to the formation of an oxide film (32) on sides (20, 22) and the bottom of trenches (18).

12. Production process according to any one of the claims 3 to 11, characterized in that after stage i' a local field oxide (36) is produced above each trench (18).

13. Production process according to any one of the claims 3 to 12, characterized in that the remainder of the mask (8) and the remainder of the second material layer (16) is eliminated by etching between stages g' and h'.

14. Production process according to any one of the claims 3 to 13, characterized in that the remainder of the first material layer (14) is eliminated between stages h' and i'.

15. Production process according to any one of the claims 2 to 14, characterized in that the filling material is silicon or silicide.

FIG. 1

FIG. 2

FIG. 3

FIG. 4

FIG. 5

FIG. 6

FIG. 7

FIG. 8

FIG 9

FIG. 10